# EUROPEAN PATENT APPLICATION

(11) **EP 4 215 924 A1**
(43) Date of publication of application: **26.07.2023**
(21) Application number: 22153264.1
(22) Date of filing: 25.01.2022
(51) Int. Cl.: G01R 19/00, H02M 7/48, H02M 1/00, H02M 3/24, B60L 53/12, H02J 50/12

(54) **DETERMINING AN ALTERNATING ELECTRICAL CURRENT OF A RESONANT CIRCUITRY ARRANGEMENT**

(71) Applicant: Wiferion GmbH, 79111 Freiburg (DE)
(72) Inventor: Springett, Nigel, 79312 Emmendingen (DE)
(74) Representative: Hofstetter, Schurack & Partner

(57) **Abstract**

The invention relates to resonant circuitry arrangement (10) comprising:
- an electric inductivity (12);
- an electric capacity (14) which is electrically connected with the electric inductivity; and
- a determination apparatus (44) for determining an alternating electric current (64) of the resonant circuitry arrangement (10);
- the electric capacity (14) comprises at least two electric capacitors (38, 40) which are connected in parallel;
- the determination apparatus (44) comprises a current sensing device (16), wherein the current sensing device (16) is electrically connected with one of the at least two electric capacitors (38) only in order to provide a respective current sense signal; and
- the determination apparatus (44) is configured to determine the alternating electric current (64) based on the current sense signal, a first electric capacity of the first capacitor (38), and a second electric capacity of the at least one second capacitor (40).

## Description

The invention relates to a method for determining an alternating electric current of a resonant circuitry arrangement having an electric inductivity and an electric capacity, wherein the electric capacity is electrically connected with the electric inductivity in order to form at least partially the resonant circuitry arrangement, the method comprising the steps: subjecting the resonant circuitry arrangement to electric energy in order to provide the alternating electric current of the resonant circuitry arrangement; and determining the alternating electric current by use of a current sensing device. The invention further relates to a resonant circuitry arrangement comprising an electric inductivity; an electric capacity which is electrically connected with the electric inductivity in order to form at least partially the resonant circuitry arrangement; and a determination apparatus for determining an alternating electric current of the resonant circuitry arrangement. Finally, the invention relates to an energy converter adapted to couple at least a first electric power network with a second electric power network, wherein the energy converter is configured to allow transmission of electric energy between the coupled electric power networks, comprising: at least one switching apparatus which is electrically coupled with the first electric power network; a resonant circuitry arrangement comprising an electric inductivity and an electric capacity which is electrically connected with the electric inductivity in order to form the resonant circuitry arrangement, wherein the resonant circuitry arrangement is coupled with the second electric power network, wherein the switching apparatus is electrically coupled with the resonant circuitry arrangement causing an alternating electric current in the resonant circuitry arrangement in order to transmit electric energy between the first electric power network and the second electric power network.

Resonant circuitry arrangements, energy converters having a resonant circuitry arrangement also referred to as resonant energy converters, as well as methods for determining an alternating current of a resonant circuitry arrangement are well known in the art so that citing of specific documents of the related art appears not to be necessary. Generally, such energy converters are used to couple electrically different electric power networks in order to allow transfer or transmission of electric energy between these coupled power networks. For example, the energy converter may couple a DC power network with an AC power network, a DC power network with another DC power network, an AC power network with another AC power network, more than two power networks or the like.

Especially, if a galvanic separation or insulation, respectively, between the coupled power networks is required, the energy converter usually comprises a resonant circuitry arrangement. The resonant circuitry arrangement in turn comprises at least one electric inductivity and at least one electric capacity, wherein a power transformer may form the electric inductivity. The power transformer usually may establish the galvanic separation or electric insulation by providing at least two different windings, namely, a primary winding and a secondary winding. These windings are galvanically separated or electrically insulated from each other. At least one of the windings may be connected with the electric capacity in order to form the resonant circuitry arrangement.

The resonant circuitry arrangement may be coupled with a switching device connected to one of the power networks so that the resonant circuitry arrangement is subjected with electric energy from this power network causing an alternating electric current flowing through the resonant circuitry arrangement. Subjecting the primary winding to this alternating electric current causes a respective voltage of the secondary winding. The secondary winding may be connected with a rectifying apparatus, which in turn may be connected with the other power network. So, the energy converter allows energy transfer between the power networks, wherein at the same, a galvanic separation or electric insulation of these networks can be achieved.

Typically, the current of the energy converter is measured on an output side of the energy converter by using a DC current sensor. As the currents to be measured are often of high value, a sense resistor such as a shunt or the like would have high losses, which is why usually a Hall Effect current sensor is used. Apart from losses involved in routing the current through such a sensor, Hall Effect current sensors suffer from a DC drift, poor frequency response, and accuracy. In this regard, US 3,984,734 discloses a protective circuit arrangement for a high-voltage capacitor bank.

Also possible but less common, it is possible to measure the alternating current of the capacity of the resonant circuitry arrangement. Usually, this current is rectified, smoothed, and a respective sensor is provided. However, also in this case, high values of the alternating electric current need to be handled.

It is an object of the invention to improve current measurement in a resonant circuitry arrangement.

As a solution, the invention proposes a method for determining an alternating current of a resonant circuitry arrangement, a resonant circuitry arrangement, and an energy converter according to the independent claims.

Preferable embodiments can be derived from the features according to the dependent claims.

According to a first aspect of the invention with regard to a generic method for determining an alternating electrical current of a resonant circuitry arrangement, it is especially proposed that the electric capacity comprises a first electric capacitor and at least one second electric capacitor, wherein the electric capacitors are connected in parallel, wherein the current sensing device senses a capacitor current of the first capacitor only and provides a respective current sense signal; and determining the value of the alternating electric current based on the current sense signal, wherein a first electric capacity of the first capacitor and a second electric capacity of the at least one second capacitor is considered.

With regard to a second aspect of the invention related to a generic resonant circuitry arrangement, it is especially proposed that the electric capacity comprises at least two electric capacitors which are connected in parallel; the determination apparatus comprises a current sensing device, wherein the current sensing device is electrically connected with one of the at least two electric capacitors only in order to sense a capacitor current of this electric capacitor only and to provide a respective current sense signal in response to the sensed capacitor current; and the determination apparatus is configured to determine the alternating electric current based on the current sense signal, a first electric capacity of the first capacitor, and a second electric capacity of the at least one second capacitor.

According to a third aspect of the invention with regard to a generic energy converter, it is especially proposed that the resonant circuitry arrangement is designed according to the invention.

It is one consideration of the invention that a current, which is passing through an electric capacity comprising at least two electric capacitors connected in parallel, is passing both capacitors. The portion of the current passing a respective one of the electric capacitors depends on a ratio of their individual capacitor capacities. Therefore, a ratio of the capacitor capacities corresponds to a ratio of the values of the current portions passing these capacitors. Moreover, the inventor found that, if all capacitor capacities are known, it is necessary to sense the electric current of one capacitor only in order to determine the whole alternating electric current passing the electric capacity formed by the parallelized capacitors. Also, the inventors found that the current sensing device does not substantially affect the accuracy of the current sensing which is passing the respective one of the capacitors. Therefore, the current sense signal provided by the current sensing device is highly representative for the real value of the electric current passing this specific capacitor. This allows that only a small portion of the complete alternating electric current passing the electric capacity needs to be sensed in order to determine the complete value of the alternating electric current. Therefore, the current sensing device can be smaller, cheaper, more reliable, and more accurate than as used in the state of the art. This allows using a current sensing device, which is designed for low power applications, in high power applications without the need to accept the deficiencies of current measuring devices for high power applications. Consequently, this also allows reducing a size and expenses for resonant circuitry arrangements as well as energy converters.

Generally, energy converters or power converters, respectively, may be used in the technical field of generating or distributing electric power. Energy converters are suited to couple at least two energy distributing networks or power networks, respectively. The DC-power network may be provided by an energy source such as a battery device, a photovoltaic module, a wind generator and/or the like. It also may be provided by a generator supplying an alternating voltage that may have one or more phases. An AC-power network may be adapted to provide two or more phases of an alternating voltage. Therefore, the energy converter can be any of, for example, a DC-DC-converter, for instance, such as a booster, a buck, or the like, an AC-DC-converter, such as an inverter, an AC-AC-converter such as a frequency converter, or the like.

Today, energy converters are usually formed as static energy converters, id est, they - contrary to dynamic energy converters - do not have any movable, especially rotatable, parts for the purpose of energy conversion. Static energy converters are usually formed as switched electric converters and include, for the purpose of energy conversion, at least one converter inductivity formed by the electric inductivity, preferably at least one converter capacity formed by the electric capacity, as well as a switching device having at least one switching element, which are connected with each other such that a predetermined switching of the switching element provides energy conversion.

A switching device comprises at least one switching element. Switching element in this disclosure preferably refers to a controllable electronic switching element, especially, a controllable electronic semiconductor switch provided, for instance, by a transistor operated in a switching mode, a thyristor, combined circuitries with such semiconductor switches, preferably with fly-back-diodes connected in parallel to the semiconductor switch, a gate-turn-off-thyristor (GTO), an insulated gate-bipolar-transistor (IGBT), combinations thereof, or the like. The switching element may also be formed by at least one field-effect-transistor, especially, metal-oxide-semiconductor-field-effect-transistor (MOSFET).

For the purpose of energy conversion or transmission, respectively, the at least one switching element is operated in a switching mode. With regard to a semiconductor switch formed by a transistor, this requires that, in a switched-on status, between connections between the transistor forming the switchable path, a very low resistance is provided so that a high current flow is enabled at a very small residual voltage. In a turned-off status, the switching path of the transistor provides a high electric resistance so that, when the voltage at the switching path is very high, substantially no or only a very small, especially, negligible current flow appears. Differing therefrom, the transistor may also be operated in a linear mode. However, this mode is usually not used for switched energy conversion or transmission, respectively.

The energy converter therefore allows an electric coupling between the power networks which the energy converter is connected with in order to provide an energy exchange between these networks. For instance, if the energy converter is linked to a DC-power network on the one hand, and to an AC-power network on the other hand, the energy converter may also provide for a suitable voltage adaption so that the energy coupling can be realized. The energy converter may be designed respectively.

Preferably, the switching device, especially its switching elements, are connected with a respective control apparatus in order to control the switching operation of the switching elements with regard to their switching status. Preferably, this connection is formed such that each of the switching elements can be controlled individually.

The control apparatus can be provided by an electronic circuitry generating respective control signals for the switching elements so that the desired switching mode of the respective switching element can be achieved. The electronic circuitry can have electronic components for generating the control signals. Moreover, the electronic circuitry can also comprise a computer for generating the respective control signals, which is controlled by a respective computer program. Especially, the control apparatus can consist of the computer only. The control apparatus may be a separate component with regard to the energy converter or its converter units. The energy converter may have one or more converter units. Each converter unit may have at least one switching device. However, it is preferably integral with energy converter, especially, its converter units.

The control apparatus is configured to control the switching element with regard to their switching operation so that the energy converter, especially its converter units, provide the desired energy conversion function between the power networks connected to the energy converter.

Moreover, the control apparatus is preferably configured to control the power to be converted by the energy converter, especially the converter units. The control apparatus may control the converter power individually for each of the converter units. In order to provide this control functionality, the control apparatus may be connected with one or more respective sensor elements, which allow determining, for instance, a respective voltage, a respective current, a respective electric power and/or the like. The at least one sensor element may be a separate component or it may be an integral component of the energy converter.

Especially, if the energy converter is configured to convert high electric power, the energy converter is usually composed of two or more converter units, which are operated in a parallel manner. This design has some technical advantages as it is possible to reduce increase the efficiency, especially with regard to a low power requirement.

The switching mode can be based on pulse wide modulation (PWM) in order to allow energy conversion with a high degree of efficiency. Such switching mode is well known in the art so that it is refrained from providing further respective details. However, other control methods may be provided such as, for instance, based on variable frequency, a combination with PWM, and/or the like.

As already discussed, especially if a galvanic separation or electric insulation is required, the use of energy converters having a resonant circuitry arrangement is recommended. In this regard, the galvanic separation or electric insulation may be provided by a transformer forming at least in part of the electric inductivity. The transformer may have two separate windings, namely, a primary winding and a secondary winding, which are galvanically separated or electrically insulated from each other. Moreover, this technology is suitable to be used by wireless, inductive power transmission systems, which may be used for supplying electric vehicles with electric energy. In this regard, cables for charging a battery of the electric vehicles can be avoided. This is also referred to as wireless charging.

Generally, a wireless, inductive power transmission system consists of a stationary and a mobile side. The stationary side is usually electrically connected with a power grid for the purpose of power supply. The mobile side is usually located on the vehicle which may be an electric vehicle. Both sides have a respective winding, which may be coupled via a magnetic field in order to allow energy transmission. Both windings may function as the power transformer discussed above. The stationary side has usually the switching device. The resonant circuitry arrangement comprising the electric capacity and the electric inductivity, wherein the electric inductivity is formed at least partially by the power transformer. On the mobile side that is on the vehicle a receiving coil corresponding to the secondary winding is provided, and a voltage and a secondary alternating current are induced in the receiving coil or secondary winding of the power transformer which belongs to the resonant circuitry arrangement. A passive or active rectifier connected with the receiving coil feeds received energy to a battery or a mobile energy system of the electric vehicle.

In such a system, the current is typically measured on an output using a DC-current sensor, which is already regarded as being disadvantageous. According to the invention, this disadvantage can be reduced or avoided by providing the electric capacity by at least two capacitors, which are connected in parallel, wherein the current sensing device senses the electric current of only one of these capacitors. As the values of the capacitor's capacities are known, the complete alternating electric current passing the electric capacity of the resonant circuitry arrangement can be determined by further consideration of a respective current sense signal of the current sensing device. Usually, a specific calculation operation may be provided processing at least values of the capacitor's capacities and the current sense signal, in order to find the value of the alternating electric current. Especially, a ratio of the capacitor's capacities can be used to calculate the value of the alternating electric current based on the value of the current sense signal. However, such processing is known in the art, which is why it is refrained from providing a respective detailed description in this regard. An electronic hardware apparatus and/or a programmable computer apparatus, or the like can provide processing.

The current sensing device may be a part of the determination apparatus. Preferably, the current sensing device may be integral with the determination apparatus. However, the current sensing device may be a component separate from the determination apparatus, which is in communication with the determination apparatus. The determination apparatus determines the value of the alternating electric current by processing the current sense signal of the current sensing device. This processing considers the individual capacities of the capacitors, which are connected in parallel. Especially, processing may be based on a ratio of the capacity of the first capacitor with regard to the capacity of the at least one second capacitor. The determination apparatus may comprise a respective hardware circuitry and/or a programmable computer. The result of the processing is a value of the alternating electric current that may be submitted to the control apparatus.

Although the invention is disclosed with regard to energy converters, the use of the invention is not limited thereto. It is, for example, also possible to use the invention with regard to oscillators, RF-transmitters, signaling and/or the like.

Therefore, the invention also allows a standard measuring construction, which can be included by many different kinds of energy converters. This also reduces the expense for construction and costs.

The switching device may comprise one or more half-bridge circuits and/or fullbridge circuits.

Especially with regard to the first aspect, according to an exemplary embodiment, it is also proposed that the first capacitor and the at least one second capacitor have a construction different from each other, wherein a step of calibrating of the current sensing device is provided. This exemplary embodiment considers that the capacitors may be foil-based capacitors, ceramic capacitors, electrolytic capacitors, or the like. If such different constructions of capacitors would be combined as the first and the at least one second capacitor, this may influence the current ratio of the capacitors, and in turn, may affect accuracy. Also, if capacitors have different tolerance ranges, this may affect the current ratio. Therefore, especially, before starting the determined operation of the method, the step of calibrating of the current sensing device may be provided in order to consider deviations caused by such constructive differences. The accuracy of the invention can be improved. Calibrating may be executed initially before starting energy conversion. However, it may executed at predetermined times or events.

Especially with regard to the second aspect of the invention and according to a further exemplary embodiment, it is proposed that the first electric capacity is smaller than the second electric capacity and the current sensing device senses the capacitor current only of the first electric capacitor. This allows reducing the expense and the size of the current sensing device without losing accuracy of current sensing. The current ratio between, for instance, the capacitor current of the second capacitor with regard to the capacitor current of the first capacitor may be higher than 1, preferably higher than 5. This further allows creating a standardized current measuring branch in the resonant circuitry arrangement including the first electric capacity and the current sensing device, which can be used for sensing the alternating current of plural different resonant circuitry arrangements or respective applications. So, it is easy to adapt the resonant circuitry arrangement to different requirements and/or power transmission, wherein the current measuring branch can be maintained.

According to a further exemplary embodiment, the current sensing device is connected in series with the respective one of the at least two electric capacitors. This allows using conventional sensing devices, which may be, for instance, based on using shunts or the like. The related disadvantages as discussed above with regard to the related art can be reduced or overcome. Especially, the high losses can be avoided.

Preferably, the respective one of the at least two electric capacitors itself comprises two capacitors which are connected in series, wherein the current sensing device is connected between these capacitors. This allows adjusting a specific electric potential in the range of the current sensing device. The resonant circuitry arrangement can be improved.

According to another embodiment, the first electric capacitor and the at least one second electric capacitor have the same construction. Preferably, they have the same tolerance range and/or the same constructive principle, namely, for instance, a ceramic capacitor, a foil-based capacitor, an electrolytic capacitor, or the like. Therefore, in this regard, a very close behavior of the capacitors can be achieved so that the accuracy of determining the alternating electric current can be improved.

Preferably, the current sensing device comprises a current transformer. The current transformer allows sensing the electric current of the capacitor without requiring a direct electric connection such as required when using a shunt. Moreover, losses can be kept small by using a respective current transformer. At the same time, accuracy and drift effects can be avoided. The current transformer may have a primary winding electrically connected with the respective electric capacity or capacitor, respectively, and a secondary winding connected with a determination apparatus for determining the value of the alternating electric current. These windings may be galvanically separated or electrically insulated from each other.

Moreover, according to an improvement, a reactive impedance of the first capacitor is at least 8 times larger, preferably 12 times larger, more preferably 15 times larger, than an impedance provided by the current transformer at a basic frequency of the alternating current. Consequently, the influence of the current transformer on the impedance of the sensing branch can be kept very small so that its influence with regard to determining the alternating electric current is also very small. The basic frequency of the alternating current conforms to the basic frequency of the resonant circuitry arrangement. Although harmonics may be present, this influence may be not essential for determining the alternating current. Therefore, a precise operation for determining the alternating current can be achieved. The impedance provided by the current transformer can be adjusted, for instance, by respective electronic components connected with the secondary side of the current transformer.

According to a further embodiment, the current sensing device is designed such that the current transformer provides an impedance in a range of about 0.01 Ω through about 1 Ω, preferably in a range of about 0.05 Ω through about 0.1 Ω. These arrangements have been found acceptable and very applicable for the intended operation.

According to a further exemplary embodiment, the current transformer has a housing fitted for surface mounted technology. This allows a standardized manufacturing of the resonant circuitry arrangement and in turn also for the energy converter. Costs can be reduced, and the reliability can be improved.

According to another exemplary embodiment, the electric capacity of the first capacitor is at least three times smaller, preferably five times smaller, more preferably ten times smaller, than the electric capacity of the at least one second capacitor. This allows keeping the losses and the requirements for the current sensing device low, especially with regard to losses, accuracy and the like.

Especially with regard to the third aspect of the invention, according to an exemplary embodiment, the electric inductivity comprises a power transformer having at least a primary winding and a secondary winding, wherein the primary winding is electrically coupled with the switching apparatus and the secondary winding is coupled with the second electric power network. In this regard, the energy converter can provide a galvanic separation or electric insulation between the coupled power networks. Energy is transferred via the inductivity during the determined operation. This includes that the primary winding may be stationary, and the secondary winding may be movable, for example, arranged at a vehicle. In this regard, the energy converter may have a stationary side and a movable side, which are differently arranged. This design can be used for supplying energy to vehicles without having the necessity of using a cable or the like. A wireless energy transmission can be achieved.

According to yet an exemplary embodiment, the energy converter is configured to couple respective DC power networks as the first electric power network and the second electric power network, wherein at least one DC current sensor is configured to sense a DC current of at least one of the DC power networks. This design allows comparing the results of the DC current sensor with the results of determining the value of the alternating current according to the invention. This allows monitoring proper operation of the current sensing device and the DC current sensor. If an unexpected deviation appears, the control apparatus of the energy converter can provide a respective message or alert or may finish operation of the energy converter. Security can be improved.

According to yet an exemplary embodiment, it is proposed that the electric capacity comprises at least two electric capacitors which are connected in parallel, wherein a current sensing device is provided which is electrically connected with one of the at least two electric capacitors only in order to sense a capacitor current of this electric capacitor only, wherein preferably the electric capacity of the first capacitor is at least three times smaller, preferably five times smaller, more preferably ten times smaller, than the electric capacity of the at least one second capacitor. The alternating electric current can be determined by measuring the electric current of one of the at least two electric capacitors only, as also detailed above. Preferably, the at least two electric capacitors can be housed in the same housing. The housing may provide respective electric connections so that, during manufacturing, one component needs to be operated only. According to one exemplary embodiment, the housing may comprise only two electric connections for the parallelized capacitors as well as two electric connections for connecting with the current sensing device. This allows achieving a simple circuitry structure.

The teaching of the present invention can be readily understood, and at least some additional specific details will appear by considering the following detailed description of some exemplary embodiments in conjunction with the accompanying drawings. In the drawings, same reference characters correspond to the same components and functions.

The invention also comprises the combinations of the features of the different embodiments.

In the following exemplary implementations of the invention are described. The figures show:
- Fig. 1: a schematic circuit diagram of a wireless, inductive power transmission system as a power converter having a resonant circuitry arrangement with a stationary side and a mobile side for supplying wirelessly a vehicle with electric energy, wherein the system comprises a DC current sensor on the mobile side;
- Fig. 2: a schematic circuit diagram such as fig. 1 an AC current sensor instead of a DC current sensor;
- Fig. 3: a schematic circuit diagram based on the schematic circuit diagram according to fig. 1 an additional current sensing branch in parallel to an electric capacity of the resonant circuitry arrangement having an AC current sensor; and
- Fig. 4: three perspective views of a current transformer forming the AC current sensor of fig. 3.

The embodiment explained in the following is a preferred embodiment of the invention. However, in the embodiment, the described components of the embodiment each represent individual features of the invention which are to be considered independently of each other and which each develop the invention also independently of each other and thereby are also to be regarded as a component of the invention in individual manner or in another than the shown combination. Furthermore, the described embodiment can also be supplemented by further features of the invention already described.

In the figures, identical reference signs indicate elements that provide the same function.

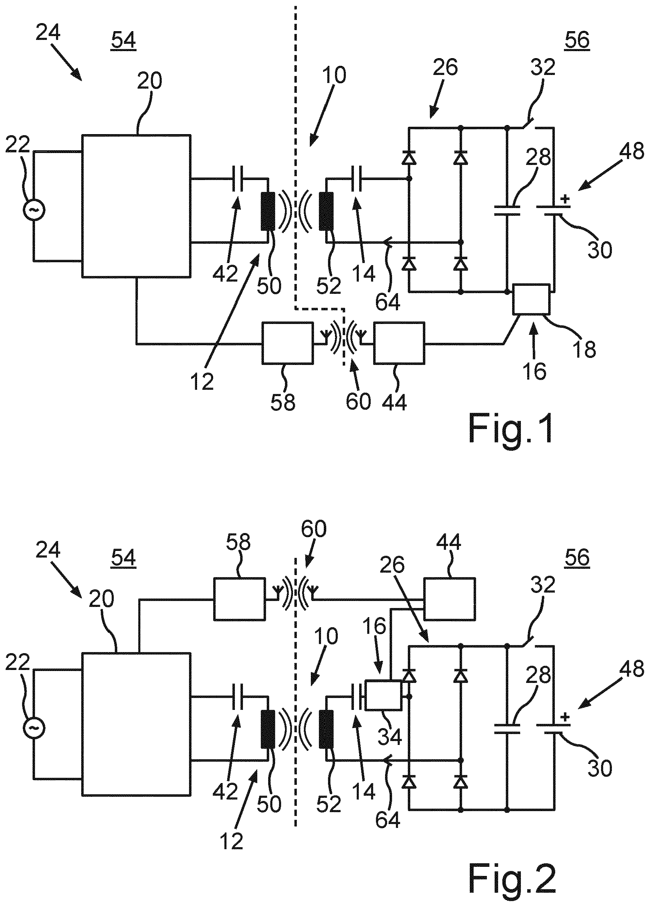

Fig. 1 shows in a schematic circuit diagram a wireless, inductive power transmission system 24 as an energy converter in order to supply electric energy to a vehicle (not shown). The vehicle may preferably be an electric driven vehicle. The wireless, inductive power transmission system 24 therefore serves for wireless charging a vehicle power network 48 of the vehicle, especially a battery 30 of the vehicle power network 48. A power grid 22 supplies the wireless, inductive power transmission system 24 with electric energy. The power grid 22 may be a public power grid. Consequently, the wireless, inductive power transmission system 24 serves to transmit wirelessly electric energy from the power grid 22 to the vehicle power network 48.

For this purpose, the wireless, inductive power transmission system 24 comprises a stationary side 54 which is located at a predetermined position, for example inside of a factory building (not shown) or the like. The wireless, inductive power transmission system 24 comprises also a vehicle side 56, which is arranged on a vehicle. For the purpose of energy transmission the vehicle is moved to the location of the stationary side 54 so that an inductive wireless energy transmission based on a magnetic field can be achieved as detailed below.

The stationary side 54 comprises a switching device 20, which may comprise one or more half bridges or full bridges, which are supplied with electric energy from the power grid 22. The wireless, inductive power transmission system 24 further comprises a resonant circuitry arrangement 10 having an electric inductivity 12, which is formed by a power transformer. The power transformer has a primary winding 50 and a secondary winding 52. The primary winding 50 is electrically coupled with the switching apparatus 20 via a capacitor 42. These components are located at the stationary side 54. The switching device 20 is communicatively coupled with a control apparatus 58. The control apparatus 58 provides respective control signals for switching elements (not shown) of the switching device 20.

The secondary winding 52 belongs to the mobile side related to the vehicle and is connected in series with an electric capacity 14. This series connection is in turn connected with a rectifying bridge 26, which is presently formed as a full bridge rectifying circuit. The rectifying bridge 26 provides a DC voltage. A smoothing capacitor 28 is exposed to this DC voltage.

The smoothing capacitor 28 is connectable with a vehicle power network 48 via a switch 32. Moreover, the smoothing capacitor 28 is connected with the vehicle power network 48 via a DC current sensor 18. The DC current sensor 18 is further connected with a determination apparatus 44, which receives a respective current signal. The determination apparatus 44 processes the current signal and provides the respective current data via a wireless communication link 60 to the control apparatus 58.

In this embodiment, the DC current sensor 18 is realized by a shunt that provides electric connection between the vehicle power network 48 of the vehicle and the smoothing capacitor 28 on a reference potential side. Since the primary winding 50 is stationary and the secondary winding 52 is mobile on the vehicle side 56, energy transfer is preferably established when the vehicle is located in the range of the location of the stationary side 54. In this regard the windings 50, 52 can be coupled via a magnetic field.

During operation, the switching device 20 causes an alternating current to flow through the capacitor 42 and the primary winding 50. This causes a respective alternating magnetic field, which affects the secondary winding 52. A respective alternating electric current 64 is induced and passes the electric capacity 14. In this regard, the resonance circuitry arrangement 10 is achieved.

Fig. 2 shows another exemplary embodiment, which is based on the embodiment according to fig. 1. In the following, only the differences with regard to the embodiment according to fig. 1 will be discussed. The further features and operation corresponds to the details discussed above, which is why it is additionally referred hereto also.

The embodiment according to fig. 2 has no DC current sensor 18. Instead, an electric connection is provided at this position. However, deviating from the before mentioned embodiment according to fig. 1, an AC current sensor 34 is provided which is connected in series with the electric capacity 14. Therefore, the AC current sensor 34 can sense the whole current passing through the electric capacity 14. The AC current sensor 34 provides a respective current signal to the determination apparatus 44, which operates correspondingly as detailed above. However, the AC current sensor 34 is subjected to a high current usually. So, a heavy and expensive component has to be provided.

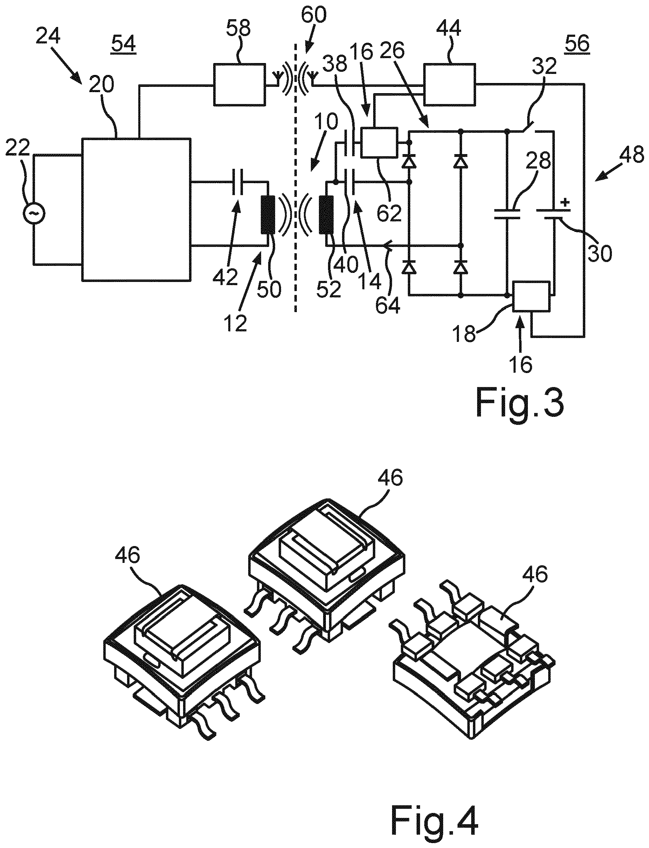

Fig. 3 shows in a further schematic circuit diagram and additional embodiment, which is also based on the embodiment according to fig. 1. In the following only the details differing from the embodiment according to fig. 1 will be discussed, which is why it is also referred to the details above.

According to fig. 3, the electric capacity 14 comprises two electric capacitors 38, 40, which are connected in parallel. The determination apparatus 44 comprises additionally an AC current sensor 62 as a current sensing device. The current sensing device 62 is connected in series with the electric capacitor 38 only in order to sense a capacitor current of this electric capacitor 38 only. The current sensing device 62 provides a respective current sense signal in response to the sensed capacitor current to the determination apparatus 44. Moreover, the determination apparatus 44 is presently configured to determine the alternating electric current 64 passing through both of the capacitors 38, 40 based on the current sense signal provided by the current sensing device 62 and by further considering an electric capacity of the first electric capacitor 38 and an electric capacity of the second capacitor 40. This allows reducing the current with which the current sensing device 62 is subjected.

In the present case, the current sensing device 62 is realized by a current transformer 46 providing an impedance of about 0.01 Ω at the operating frequency of the energy converter 24. In alternative embodiments, the impedance may be in a range of about 0.01 Ω to about 1 Ω. In this regard, the reactive impedance of the first capacitor 38 is respectively larger than the impedance of the current transformer 48 at a basic frequency of the alternating electric current 64. This ensures that the current transformer 48 has no significant influence on the total current passing the both capacitors 38, 40. Therefore, it is possible to keep the current passing the current transformer 46 small by respectively choosing the ratio between the capacities of the capacitors 38, 40. Preferably, the capacity of the capacitor 40 is larger than the capacity of the capacitor 38.

This allows providing a very small design for the current transformer 46 so that a SMD (surface mounted device) design can be achieved as shown in fig. 4.

Fig. 4 shows the transformer 46 in an SMD design in three different perspective views. A left view shows the current transformer 46 in a perspective plan view. A medium view shows the same transformer 46 rotated about a longitudinal axis. A right view shows a perspective bottom view of the current transformer 46.

Although the invention is described with regard to a wireless, inductive power transmission system, the invention is not limited thereto. It is also possible to use the invention in a similar way for conventional converters such as DC/DC-converters, AC/AC-converters, DC/AC-converters and the like. Additionally, the invention is not limited to be applied to the mobile side of a wireless, inductive power transmission system. It can also be applied to the stationary side of the wireless, inductive power transmission system or one both sides, the mobile side and the stationary side.

Although various aspects of the invention are set out in the independent claims, other aspects of the invention comprise other combinations of features from the described embodiments and/or the dependent claims with the features of the independent claims, and not solely the combinations explicitly set out in the claims.

This is also covered during that, while the above describes exemplary embodiments of the invention, this description should not be regarded as limiting the scope. Rather, there are several variations and modifications that may be made without departing from the scope of the present invention as defined in the claims.

### REFERENCE CHARACTERS

- 10: resonant circuitry arrangement
- 12: electric inductivity
- 14: electric capacity
- 16: current sensing device
- 18: DC current sensor
- 20: switching device
- 22: power grid
- 24: energy converter
- 26: rectifying bridge
- 28: smoothing capacitor
- 30: battery
- 32: switch
- 34: AC current sensor
- 38: first capacitor
- 40: second capacitor
- 42: third capacitor
- 44: determination apparatus
- 46: current transformer
- 48: vehicle power network
- 50: primary winding
- 52: secondary winding
- 54: stationary side
- 56: vehicle side
- 58: control apparatus
- 60: wireless communication link
- 62: AC current sensor
- 64: alternating electric current

## Claims

1. A method for determining an alternating electric current (64) of a resonant circuitry arrangement (10) having an electric inductivity (12) and an electric capacity (14), wherein the electric capacity (14) is electrically connected with the electric inductivity (12) in order to form at least partially the resonant circuitry arrangement (10), the method comprising the steps:
- subjecting the resonant circuitry arrangement (10) to electric energy in order to provide the alternating electric current (64) of the resonant circuitry arrangement (10); and
- determining the alternating electric current (64) by use of a current sensing device (16);
**characterized in that**
- the electric capacity (14) comprises a first electric capacitor (38) and at least one second electric capacitor (40), wherein the electric capacitors (38, 40) are connected in parallel, wherein the current sensing device (16) senses a capacitor current of the first capacitor (38) only and provides a respective current sense signal; and
- determining the value of the alternating electric current (64) based on the current sense signal, wherein a first electric capacity of the first capacitor (38) and a second electric capacity of the at least one second capacitor (40) is considered.

2. The method according to claim 1, **characterized in that** the first capacitor (38) and the at least one second capacitor (40) have a construction different from each other, wherein a step of calibrating of the current sensing device (16) is provided.

3. A resonant circuitry arrangement (10) comprising:
- an electric inductivity (12);
- an electric capacity (14) which is electrically connected with the electric inductivity in order to form at least partially the resonant circuitry arrangement (10); and
- a determination apparatus (44) for determining an alternating electric current (64) of the resonant circuitry arrangement (10);
**characterized in that**
- the electric capacity (14) comprises at least two electric capacitors (38, 40) which are connected in parallel;
- the determination apparatus (44) comprises a current sensing device (16), wherein the current sensing device (16) is electrically connected with one of the at least two electric capacitors (38) only in order to sense a capacitor current of this electric capacitor (38) only and to provide a respective current sense signal in response to the sensed capacitor current; and
- the determination apparatus (44) is configured to determine the alternating electric current (64) based on the current sense signal, a first electric capacity of the first capacitor (38), and a second electric capacity of the at least one second capacitor (40).

4. The resonant circuitry arrangement according to claim 3, **characterized in that** the first electric capacity is smaller than the second electric capacity and the current sensing device (16) senses the capacitor current only of the first electric capacitor (38).

5. The resonant circuitry arrangement according to claim 3 or 4, **characterized in that** the current sensing device (16) is connected in series with the respective one of the at least two electric capacitors (38).

6. The resonant circuitry arrangement according to claim 5, **characterized in that** the respective one of the at least two electric capacitors (38) itself comprises two capacitors which are connected in series, wherein the current sensing device (16) is connected between these capacitors.

7. The resonant circuitry arrangement according to anyone of the claims 3 through claim 6, **characterized in that** the first electric capacitor (38) and the at least one second electric capacitor (40) have the same construction.

8. The resonant circuitry arrangement according to anyone of the claims 3 through 7, **characterized in that** the current sensing device (16) comprises a current transformer (46).

9. The resonant circuitry arrangement according to claim 8, **characterized in that** a reactive impedance of the first capacitor (38) is at least 8 times larger, preferably 12 times larger, more preferably 15 times larger, than an impedance provided by the current transformer (46) at a basic frequency of the alternating current.

10. The resonant circuitry arrangement according to claim 8 or 9, **characterized in that** the current sensing device (16) is designed such that the current transformer (46)provides an impedance in a range of 0.01 Ω through 1 Ω, preferably in a range of 0.05 Ω through 0.1 Ω.

11. The resonant circuitry arrangement according to anyone of the claims 8 through 10, **characterized in that** the current transformer (46) has a housing fitted for surface mounted technology.

12. An energy converter (24) adapted to couple at least a first electric power network (22) with a second electric power network (48), wherein the energy converter (24) is configured to allow transmission of electric energy between the coupled electric power networks (22, 48), comprising:
- at least one switching apparatus (20) which is electrically coupled with the first electric power network (22);
- a resonant circuitry arrangement (10) comprising an electric inductivity (12) and an electric capacity (14) which is electrically connected with the electric inductivity (12) in order to form the resonant circuitry arrangement (10), wherein the resonant circuitry arrangement (10) is coupled with the second electric power network (48);
- wherein the switching apparatus (20) is electrically coupled with the resonant circuitry arrangement (10) causing an alternating electric current (64) in the resonant circuitry arrangement (10) in order to transmit electric energy between the first electric power network (22) and the second electric power network (48);
**characterized in that**
the resonant circuitry arrangement (10) is formed by a resonant circuitry arrangement (10) of anyone of the claims 3 through 11.

13. The energy converter according to claim 12, **characterized in that** the electric inductivity (14) comprises a power transformer having at least a primary winding (50) and a secondary winding (52), wherein the primary winding (50) is electrically coupled with the switching apparatus (20) and the secondary winding (52) is coupled with the second electric power network (48).

14. The energy converter according to claim 12 or 13, **characterized in that** the energy converter (24) is configured to couple respective DC power networks as the first electric power network and the second electric power network, wherein at least one DC current sensor (18) is configured to sense a DC current of at least one of the DC power networks (48).

15. The energy converter according to anyone of the claims 12 through 14, **characterized in that** the electric capacity (14) comprises at least two electric capacitors (38, 40) which are connected in parallel, wherein a current sensing device (16) is provided which is electrically connected with one of the at least two electric capacitors (38) only in order to sense a capacitor current of this electric capacitor (38) only, wherein preferably the electric capacity of the first capacitor (38) is at least three times smaller, preferably five times smaller, more preferably ten times smaller, than the electric capacity of the at least one second capacitor (40).
